# EUROPEAN PATENT APPLICATION

(11) **EP 4 597 842 A1**
(43) Date of publication of application: **06.08.2025**
(21) Application number: 24155418.7
(22) Date of filing: 02.02.2024
(51) Int. Cl.: H03K 17/16, H02M 1/08, H02M 3/157, H05B 45/305, H05B 45/38, H05B 45/39

(54) **SWITCHED-MODE POWER SUPPLY AND LUMINAIRE COMPRISING THE SAME**

(71) Applicant: Tridonic GmbH & Co. KG, 6851 Dornbirn (AT)
(72) Inventor: Schneider, Miguel Philipp, 6851 Dornbirn (AT); Romano, Fabio, 6851 Dornbirn (AT); Lochmann, Frank, 6851 Dornbirn (AT)
(74) Representative: Rupp, Christian

(57) **Abstract**

Disclosed is a switched-mode power supply, SMPS (1, 1A, 1B), comprising a reactive circuit (11); a first switch (12, S₁), interposed between the reactive circuit (11) and a ground electric potential of the SMPS (1, 1A, 1B), and configured to short-circuit a voltage (V_{DS}) across the first switch (12, S₁) in accordance with a first drive voltage (V_{GS}) applied to the first switch (12, S₁); and a control circuit (14), multi-connected to a drive terminal of the first switch (12, S₁), and configured to apply the first drive voltage (V_{GS}) to the first switch (12, S₁) in accordance with a conduction time to short-circuit the voltage (V_{DS}) across the first switch (12, S₁); measure a duration (31, t) of a Miller plateau (3) in an emerging waveform of the first drive voltage (V_{GS}); and operate the SMPS (1, 1A, 1B) in dependence of the measured duration (31, t) of the Miller plateau (3). This enables determining the voltage (V_{DS}) across the first switch (12, S₁) without requiring any excess components.

## Description

### Technical Field

The present disclosure relates generally to the field of lighting technology, and in particular to a switched-mode power supply and a luminaire comprising the same.

### Background Art

Certain implementations of switched-mode power supplies (SMPS), such as zero-voltage switching or voltage regulation require determining a voltage across its switches.

Typically, this involves excess components and increases a PCB footprint of the SMPS.

### Summary

It is an object to overcome the above-mentioned and other drawbacks.

The foregoing and other objects are achieved by the features of the independent claims. Further implementation forms are apparent from the dependent claims, the description and the figures.

According to a first aspect, a switched-mode power supply, SMPS is provided, comprising a reactive circuit; a first switch, interposed between the reactive circuit and a ground electric potential of the SMPS, and configured to short-circuit a voltage across the first switch in accordance with a first drive voltage applied to the first switch; and a control circuit, multi-connected to a drive terminal of the first switch, and configured to apply the first drive voltage to the first switch in accordance with a conduction time to short-circuit the voltage across the first switch; measure a duration of a Miller plateau in an emerging waveform of the first drive voltage; and operate the SMPS in dependence of the measured duration of the Miller plateau.

The reactive circuit may comprise an inductor connected in series with the first switch.

For operating the SMPS in dependence of the measured duration of the Miller plateau, the control circuit may further be configured to determine the voltage across the first switch before the short-circuiting in dependence of the measured duration of the Miller plateau; and regulate the conduction time of the first switch in accordance with the determined voltage and a setpoint value of the voltage.

The SMPS may further comprise a switching half-bridge, comprising the first switch and a second switch. The reactive circuit may be connected between a common electric potential of the first switch and the second switch and the ground electric potential of the SMPS, and may comprise one of: an LLC resonant tank circuit, and an LCC resonant tank circuit.

For operating the SMPS in dependence of the measured duration of the Miller plateau, the control circuit may further be configured to prevent or delay a short-circuiting of a voltage across the second switch in dependence of the measured duration of the Miller plateau.

For operating the SMPS in dependence of the measured duration of the Miller plateau, the control circuit may further be configured to prevent or delay the short-circuiting of the voltage across the second switch if the measured duration of the Miller plateau exceeds a maximum threshold.

The SMPS may further comprise a first resistor interposed between a drive circuitry of the control circuit and the drive terminal of the first switch.

The SMPS may further comprise a filter circuit, comprising a capacitor and a second resistor connected in series between the drive terminal of the first switch and the ground electric potential of the SMPS. A common electric potential of the capacitor and the second resistor may be connected to an analog/digital converter, ADC, of the control circuit.

The control circuit may comprise one or more of: a proportional-integral, PI, controller, and an application-specific integrated circuit, ASIC.

The ASIC may comprise a counter, configured to measure the duration of the Miller plateau in the emerging waveform of the first drive voltage in a range of single-digit nanoseconds up to triple-digit nanoseconds.

The SMPS may further comprise a resistive voltage divider circuit, configured to provide an indication of the voltage across the first switch.

The first switch may comprise a field-effect transistor, FET.

According to a second aspect, a luminaire is provided, comprising an SMPS of the first aspect, and a load comprising an LED light source operable by means of the SMPS.

### Advantageous Effects

According to the present disclosure, a drain-source voltage V_{DS} across a FET can be measured indirectly by analyzing the gate-source voltage V_{GS} applied to its drive terminal, as set out in publication *Barkhordarian, Power MOSFET Basics,* for example.

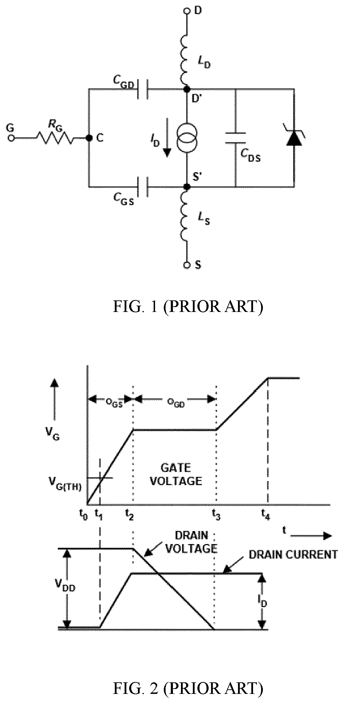

FIG. 1 illustrates an equivalent circuit of a power MOSFET, and FIG. 2 illustrates waveforms associated with its switch-on (corresponding to FIG. 11(b) and FIG. 13(b) of the *Barkhordarian* publication).

When applying a drive voltage to the FET at time instant t₀, the gate-source voltage V_{G(S)} starts to increase. At time instant t₁, the gate-source voltage V_{G(S)} exceeds a threshold voltage Vₜₕ of the FET. The device is forced into conduction, a drain current I_{D} starts to flow and a gate-source capacitance C_{GS} starts to charge. The gate-source capacitance C_{GS} continues to charge and the gate-source voltage V_{GS} continues to rise while the drain current I_{D} rises proportionally. With the gate-source capacitance C_{GS} fully charged at time instant t₂, the drain current I_{D} becomes constant, the drain-source voltage V_{D(S)} starts to fall and the drive current starts to charge the Miller capacitance C_{GD} (or) and the gate-source voltage V_{G(S)} becomes constant. Once the Miller capacitance C_{GD} is also fully charged at time instant t₃, the gate-source voltage V_{G(S)} starts increasing again until it reaches the supply voltage at time instant t₄.

Note the emerging Miller plateau of the gate-source voltage V_{G(S)} between time instants t₂ and t₃, which is closely related with the drain-source voltage V_{D(S)}: The higher the drain-source voltage V_{D(S)}, the longer the duration t = t₃ - t₂ of the Miller plateau, and vice versa.

In other words, given the characterization t= f(V_{DS}) or V_{DS} = f⁻¹(t) for the particular FET, it is possible to derive the drain-source voltage V_{D(S)} from a measurement of the duration t of the Miller plateau.

It is thus possible to determine the drain-source voltage V_{DS} just before the short-circuiting of the FET without any excess components.

First, the SMPS circuit may require less components and PCB footprint.

The determined drain-source voltage V_{DS} may serve for regulation purposes, for example.

Second, a time instant of zero-voltage switching may be optimized by minimizing the duration t of the Miller plateau, thereby optimizing an efficiency of the SMPS.

Third, by defining a maximum duration of the Miller plateau, the FET may be protected.

### Brief Description of Drawings

The above-described aspects and implementations will now be explained with reference to the accompanying drawings, in which the same or similar reference numerals designate the same or similar elements.

The drawings are to be regarded as being schematic representations, and elements illustrated in the drawings are not necessarily shown to scale. Rather, the various elements are represented such that their function and general purpose become apparent to those skilled in the art.
- FIG. 1: illustrates an equivalent circuit of a power MOSFET.
- FIG. 2: illustrates waveforms associated with a switch-on of the FET of FIG. 1.
- FIG. 4: illustrates an SMPS in accordance with the present disclosure having a single switch; and

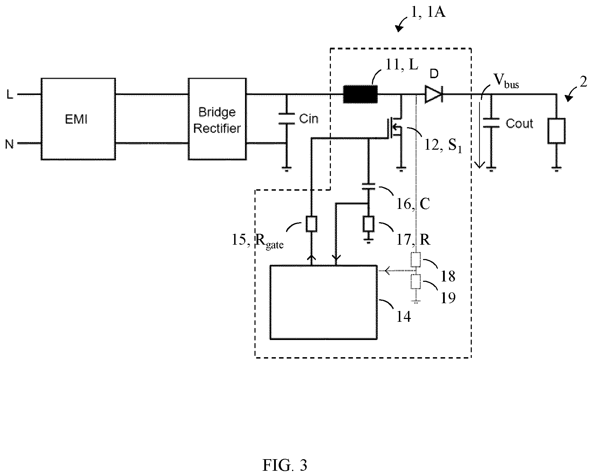

- FIG. 3: illustrates an SMPS in accordance with the present disclosure having a switching half-bridge;

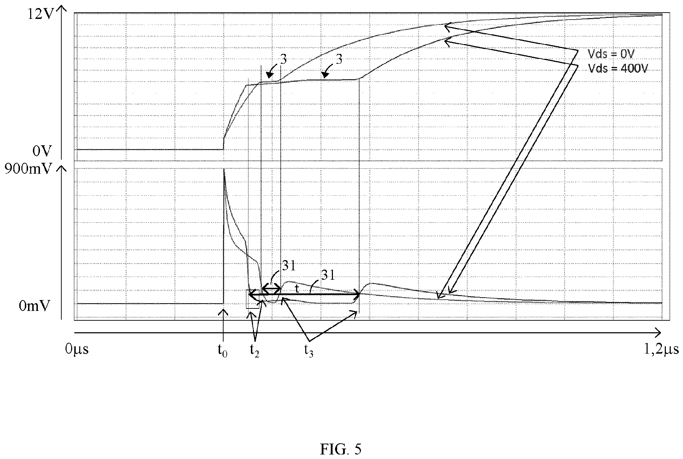

- FIG. 5: illustrates waveforms associated with a switch-on of the first switch of FIGs. 2, 3 in accordance with the present disclosure.

### Detailed Descriptions of Drawings

In the following description, reference is made to the accompanying drawings, which form part of the disclosure, and which show, by way of illustration, specific aspects of implementations of the present disclosure or specific aspects in which implementations of the present disclosure may be used. It is understood that implementations of the present disclosure may be used in other aspects and comprise structural or logical changes not depicted in the figures. The following detailed description, therefore, is not to be taken in a limiting sense, and the scope of the present disclosure is defined by the appended claims.

For instance, it is understood that a disclosure in connection with a described method may also hold true for a corresponding apparatus or system configured to perform the method and vice versa. For example, if one or a plurality of specific method steps are described, a corresponding device may include one or a plurality of units, e.g. functional units, to perform the described one or plurality of method steps (e.g. one unit performing the one or plurality of steps, or a plurality of units each performing one or more of the plurality of steps), even if such one or more units are not explicitly described or illustrated in the figures. On the other hand, for example, if a specific apparatus is described based on one or a plurality of units, e.g. functional units, a corresponding method may include one step to perform the functionality of the one or plurality of units (e.g. one step performing the functionality of the one or plurality of units, or a plurality of steps each performing the functionality of one or more of the plurality of units), even if such one or plurality of steps are not explicitly described or illustrated in the figures. Further, it is understood that the features of the various exemplary implementations and/or aspects described herein may be combined with each other, unless specifically noted otherwise.

FIG. 3 illustrates an SMPS 1, 1A in accordance with the present disclosure having a single switch 12.

The SMPS 1, 1A comprises a reactive circuit 11 and a first switch 12, S₁.

In the implementation of FIG. 3, the reactive circuit 11 may comprise an inductor L connected in series with the first switch 12, S₁.

The first switch 12, S₁ may comprise a field-effect transistor, FET.

The first switch 12, S₁ is interposed between the reactive circuit 11 and a ground electric potential of the SMPS 1, 1A.

The first switch 12, S₁ is configured to short-circuit a voltage V_{DS} across the first switch 12, S₁ in accordance with a first drive voltage V_{GS} applied to the first switch 12, S₁.

The SMPS 1, 1A may further comprise a diode D placed between a common terminal of the reactive circuit 11 and the first switch 12, S₁.

The SMPS 1, 1A may thus form a boost converter circuit, being operable as a power factor correction (PFC) circuit configured to regulate an output/bus voltage V_{bus}.

On its input side, the SMPS 1, 1A may further comprise an EMI filter stage (EMI) and bridge rectifier on its input.

On its output side, the SMPS 1, 1A may further comprise an output capacitor Cₒᵤₜ for smoothing of its output/bus voltage V_{bus}.

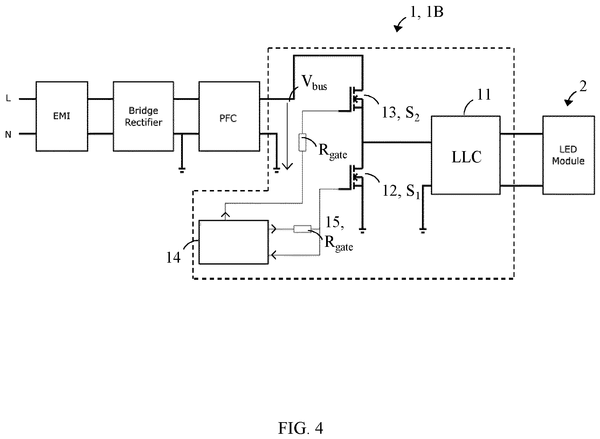

Generally, a load 2 of the SMPS 1, 1A may comprise an LED light source and may further comprise a DC/DC converter (similar to the example of Fig. 4 below) powering said LED light source.

The SMPS 1, 1A may form a luminaire 1, 2 in combination with such a load 2 being operable by means of the SMPS 1, 1A.

The SMPS 1, 1A further comprises a control circuit 14.

In particular, the control circuit 14 may comprise an application-specific integrated circuit, ASIC.

The control circuit 14 is multi-connected to a drive terminal (i.e., gate) of the first switch 12, S₁ as follows.

First, the SMPS 1, 1A may further comprise a first ohmic resistor 15, R_{gate} interposed between a drive circuitry of the control circuit 14 and the drive terminal of the first switch 12, S₁. This connection enables driving the switch 12 by the control circuit 14.

Second, the SMPS 1, 1A may further comprise a (high-pass) filter circuit, comprising a capacitor 16, C and a second resistor 17, R connected in series between the drive terminal of the first switch 12, S₁ and the ground electric potential of the SMPS 1, 1A. A common electric potential of the capacitor 16, C and the second resistor 17, R may be connected to an analog/digital converter, ADC, of the control circuit 14. This connection enables sensing an emerging waveform of the first drive voltage V_{GS} by the control circuit 14.

The control circuit 14 is configured to apply the first drive voltage V_{GS} to the first switch 12, S₁ in accordance with a conduction time to short-circuit the voltage V_{DS} across the first switch 12, S₁ for said conduction time. In other words, the first switch 12, S₁ intermittently short-circuits the voltage V_{DS} across itself.

The control circuit 14 is further configured to measure a duration 31, t of a Miller plateau 3 in an emerging waveform of the first drive voltage V_{GS}.

To this end, the ASIC of the control circuit 14 may comprise a counter (not shown), configured to measure the duration 31, t of the Miller plateau 3 in the emerging waveform of the first drive voltage V_{GS} in a range of single-digit nanoseconds up to triple-digit nanoseconds.

It is thus possible to determine the drain-source voltage V_{DS} just before the short-circuiting of the first switch 12, S₁ without any excess components. In the example of FIG. 3, this enables an inference on the output/bus voltage V_{bus} of the SMPS 1, 1A.

The control circuit 14 is further configured to operate the SMPS 1,1A in dependence of the measured duration 31, t of the Miller plateau 3.

For operating the SMPS 1, 1A in dependence of the measured duration 31, t of the Miller plateau 3, the control circuit 14 may further be configured to determine the voltage V_{DS} across the first switch 12, S₁ just before the short-circuiting in dependence of the measured duration 31, t of the Miller plateau 3, and regulate the conduction time of the first switch 12, S₁ in accordance with the determined voltage V_{DS} and a setpoint value of the voltage.

To this end, the control circuit 14 may comprise a proportional-integral, PI, controller for the regulation (i.e., closed-loop control).

Although it is possible to determine the drain-source voltage V_{DS} across the first switch 12, S₁ just before its short-circuiting without any excess components, the SMPS 1, 1A may still have a resistive voltage divider circuit 18, 19 configured to directly provide an indication of the voltage V_{DS} across the first switch 12, S₁.

The measured duration 31, t of the Miller plateau 3 may be compared with a lookup table. Such lookup table may be programmed once, e.g. during production of the driver. For such programming of the lookup table the bus voltage Vbus over the output capacitor Cout may be measured by an external calibration circuit. The calibration circuit may further be designed to measure the duration 31, t of the Miller plateau 3 in relation to the bus voltage V_{bus} and may store the information about this relation in the lookup table. It may be also be possible that the lookup table is provided from external sources e.g. from a datasheet, wherein the relevant information from the datasheet will be extracted and provided to the control circuit 14, e.g. via a dimming control interface or a programming interface.

FIG. 4 illustrates an SMPS 1, 1B in accordance with the present disclosure having a switching half-bridge 12, 13.

The SMPS 1, 1B may form part of a luminaire 1, 2 in combination with an LED light source 2 operable by means of the SMPS 1, 1B.

On its input, the SMPS 1, 1B may comprise an electromagnetic interference (EMI) filter stage and a bridge rectifier.

The SMPS 1, 1B may further comprise a boost converter circuit being operable as a power factor correction (PFC) circuit (similar to the example of Fig. 3 above). The PFC may provide a stabilized bus voltage V_{bus} to the SMPS 1, 1B.

The SMPS 1, 1B comprises a reactive circuit 11.

The reactive circuit 11 may comprise one of: an LLC resonant tank circuit, and an LCC resonant tank circuit.

The SMPS 1, 1B further comprises a first switch 12, S₁, interposed between the reactive circuit 11 and a ground electric potential of the SMPS 1, 1B.

The SMPS 1, 1B may further comprise a (high-side) second switch 13, S₂ forming a switching half-bridge in combination with the (low-side) first switch 12, S₁.

The first switch 12, S₁ and the second switch 13, S₂ may respectively comprise a field-effect transistor, FET.

The reactive circuit 11 may be connected between a common electric potential of the first switch 12, S₁ and the second switch 13, S₂ and the ground electric potential of the SMPS 1, 1B.

The first switch 12, S₁ is configured to short-circuit a voltage V_{DS} across the first switch 12, S₁ in accordance with a first drive voltage V_{GS} applied to the first switch 12, S₁.

The SMPS 1, 1B further comprises a control circuit 14.

In particular, the control circuit 14 may comprise an application-specific integrated circuit, ASIC.

The control circuit 14 is multi-connected to a drive terminal (i.e., gate) of the first switch 12, S₁ as follows.

First, the SMPS 1, 1B may further comprise a first ohmic resistor 15, R_{gate} interposed between a drive circuitry of the control circuit 14 and the drive terminal of the first switch 12, S₁. Likewise, an ohmic resistance R_{gate} may be interposed between a further drive circuitry of the control circuit 14 and the drive terminal of the second switch 13, S₂. These connections enable driving the switches 12, 13 by the control circuit 14.

Second, the SMPS 1, 1B may further comprise a (high-pass) filter circuit (see FIG. 4 for an exemplary implementation), comprising a capacitor 16, C and a second resistor 17, R connected in series between the drive terminal of the first switch 12, S₁ and the ground electric potential of the SMPS 1, 1B. A common electric potential of the capacitor 16, C and the second resistor 17, R may be connected to an analog/digital converter, ADC, of the control circuit 14. This connection enables sensing an emerging waveform of the first drive voltage V_{GS} by the control circuit 14.

The control circuit 14 is configured to apply the first drive voltage V_{GS} to the first switch 12, S₁ in accordance with a conduction time to short-circuit the voltage V_{DS} across the first switch 12, S₁ for said conduction time.

The control circuit 14 may further be configured to alternatingly apply a second drive voltage to the second switch 13, S₂ in accordance with the conduction time to short-circuit a voltage across the first switch 12, S₁ for said conduction time. In other words, the first switch 12, S₁ and the second switch 13, S₂ may short-circuit the voltages across themselves in turns, thereby generating a square-wave voltage across the reactive circuit 11.

The control circuit 14 is further configured to measure a duration 31, t of a Miller plateau 3 in an emerging waveform of the first drive voltage V_{GS}.

To this end, the ASIC of the control circuit 14 may comprise a counter (not shown), configured to measure the duration 31, t of the Miller plateau 3 in the emerging waveform of the first drive voltage V_{GS} in a range of single-digit nanoseconds up to triple-digit nanoseconds.

Typically the measuring of the duration 31, t of the Miller plateau 3 would be done at the first (low-side) switch 12, S₁ as shown in Fig. 4. A sensing on the gate of the second (high-side) switch 13, S₂ would be difficult to engineer as the sensed voltage ranges up to 400V whereas the signal on the gate of low side switch is in the range of some volts (e.g. 5 V). As the switching of the halfbridge is done with 50% duty cycle (alternating) it can be sufficient just to sense the low side signal and extrapolate the information for the high side switch.

It is thus possible to determine the drain-source voltage V_{DS} just before the short-circuiting of the first switch 12, S₁ without any excess components. In the example of FIG. 4, this enables an inference on the input/bus voltage V_{bus} of the SMPS 1, 1B.

The control circuit 14 is further configured to operate the SMPS 1, 1B in dependence of the measured duration 31, t of the Miller plateau 3.

For operating the SMPS 1, 1B in dependence of the measured duration 31, t of the Miller plateau 3, the control circuit 14 may further be configured to prevent or delay a short-circuiting of a voltage across the second switch 13, S₂ in dependence of the measured duration 31, t of the Miller plateau 3, in particular if the measured duration 31, t of the Miller plateau 3 exceeds a maximum threshold.

The SMPS 1, 1B may be designed to switch off the alternative clocking of the first switch 12, S₁ and the second switch 13, S₂ if the measured duration 31, t of the Miller plateau 3 exceeds the maximum threshold. For example, this may comprise a temporary protective shut down of the half bridge, e.g., by premature opening of both switches 12, 13 at least for a certain time period, or a persistent protective shut-down in case of repetitive threshold crossings.

Similarly to the implementation of FIG. 3, the SMPS 1, 1B may further comprise a resistive voltage divider circuit 18, 19 (not shown) configured to directly provide an indication of the voltage V_{DS} across the first switch 12, S₁.

FIG. 5 illustrates waveforms associated with a switch-on of the first switch 12 of FIGs. 3, 4 in accordance with the present disclosure.

An upper portion of FIG. 5 shows emerging waveforms of the gate-source voltage (i.e., first drive voltage) V_{GS} for different drain-source voltages V_{DS} of 0V and 400V, respectively.

A lower portion of FIG. 5 depicts corresponding filtered waveforms of the gate-source voltage V_{GS} as available at the common electric potential of the capacitor 16, C and the second resistor 17, R of the (high-pass) filter circuit.

It applies to both drain-source voltages V_{DS} that the gate-source voltage V_{G(S)} starts to increase when applying a drive voltage to the FET at time instant t₀. The gate-source capacitance C_{GS} starts and continues to charge and the gate-source voltage V_{GS} continues to rise. With the gate-source capacitance C_{GS} fully charged at time instant t₂, the drive current starts to charge the Miller capacitance C_{GD} and the gate-source voltage V_{G(S)} becomes constant. Once the Miller capacitance C_{GD} is also fully charged at time instant t₃, the gate-source voltage V_{G(S)} starts increasing again until it reaches the supply voltage.

Note the emerging Miller plateaus 3 of the gate-source voltage V_{GS} between time instants t₂ and t₃, which are closely related with the respective drain-source voltage V_{DS}: The higher the drain-source voltage V_{DS}, the longer the duration t = t₃ - t₂ of the respective Miller plateau 3, and vice versa.

It is thus possible to compare the filtered waveforms of the gate-source voltage V_{GS} with a threshold (e.g., about 100mV in the examples of FIG. 5) to measure the duration 31, t of the respective Miller plateau 3 in the emerging waveforms of the first drive voltage V_{GS}.

This threshold for the filtered waveforms of the gate-source voltage V_{GS} has to be predefined. For example, this may be done during calibration as a final manufacturing step.

The present disclosure is intended to avoid an additional sensing of the bus voltage V_{bus} but for the calibration step this voltage has to be measured. It would also be possible to store the datasheet parameters of the switch in the driver but it may be necessary to perform some calibration due to component tolerances.

The present disclosure has been described in conjunction with various implementations as examples. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation. A computer program may be stored/distributed on a suitable medium, such as an optical storage medium or a solid-state medium supplied together with or as part of other hardware, but may also be distributed in other forms, such as via the Internet or other wired or wireless telecommunication systems.

## Claims

1. A switched-mode power supply, SMPS (1, 1A, 1B), comprising
a reactive circuit (11);
a first switch (12, S₁),
interposed between the reactive circuit (11) and a ground electric potential of the SMPS (1, 1A, 1B), and
configured to short-circuit a voltage (V_{DS}) across the first switch (12, S₁) in accordance with a first drive voltage (V_{GS}) applied to the first switch (12, S₁); and
a control circuit (14),
connected to a drive terminal of the first switch (12, S₁), and configured to
- apply the first drive voltage (V_{GS}) to the first switch (12, S₁) in accordance with a conduction time to short-circuit the voltage (V_{DS}) across the first switch (12, S₁);
- measure a duration (31, t) of a Miller plateau (3) in an emerging waveform of the first drive voltage (V_{GS}); and
- operate the SMPS (1, 1A, 1B) in dependence of the measured duration (31, t) of the Miller plateau (3).

2. The SMPS (1, 1A) of claim 1,
the reactive circuit (11) comprising an inductor (L) connected in series with the first switch (12, S₁).

3. The SMPS (1, 1A) of claim 2,
for operating the SMPS (1, 1A) in dependence of the measured duration (31, t) of the Miller plateau (3), the control circuit (14) is further configured to
- determine the voltage (V_{DS}) across the first switch (12, S₁) before the short-circuiting in dependence of the measured duration (31, t) of the Miller plateau (3); and
- regulate the conduction time of the first switch (12, S₁) in accordance with the determined voltage (V_{DS}) and a setpoint value of the voltage.

4. The SMPS (1, 1B) of claim 1, further comprising
a switching half-bridge, comprising the first switch (12, S₁) and a second switch (13, S₂);
the reactive circuit (11) connected between a common electric potential of the first switch (12, S₁) and the second switch (13, S₂) and the ground electric potential of the SMPS (1, 1B), and comprising one of:
- an LLC resonant tank circuit, and
- an LCC resonant tank circuit.

5. The SMPS (1, 1B) of claim 4,
for operating the SMPS (1, 1B) in dependence of the measured duration (31, t) of the Miller plateau (3), the control circuit (14) is further configured to
- prevent or delay a short-circuiting of a voltage across the second switch (13, S₂) in dependence of the measured duration (31, t) of the Miller plateau (3).

6. The SMPS (1, 1B) of claim 5,
for operating the SMPS (1, 1B) in dependence of the measured duration (31, t) of the Miller plateau (3), the control circuit (14) is further configured to
- prevent or delay the short-circuiting of the voltage across the second switch (13, S₂) if the measured duration (31, t) of the Miller plateau (3) exceeds a maximum threshold.

7. The SMPS (1, 1A, 1B) of any one of the preceding claims, further comprising
a first resistor (15, R_{gate}) interposed between a driver of the control circuit (14) and the drive terminal of the first switch (12, S₁).

8. The SMPS (1, 1A, 1B) of any one of the preceding claims, further comprising
a filter circuit, comprising a capacitor (16, C) and a second resistor (17, R) connected in series between the drive terminal of the first switch (12, S₁) and the ground electric potential of the SMPS (1, 1A, 1B); and
a common electric potential of the capacitor (16, C) and the second resistor (17, R) connected to an analog/digital converter, ADC, of the control circuit (14).

9. The SMPS (1, 1A, 1B) of any one of the preceding claims,
the control circuit (14) comprising one or more of:
- a proportional-integral, PI, controller, and
- an application-specific integrated circuit, ASIC.

10. The SMPS (1, 1A, 1B) of claim 9,
the ASIC comprising a counter, configured to measure the duration (31, t) of the Miller plateau (3) in the emerging waveform of the first drive voltage (V_{GS}) in a range of single-digit nanoseconds up to triple-digit nanoseconds.

11. The SMPS (1, 1A, 1B) of any one of the preceding claims, further comprising
a resistive voltage divider circuit (18, 19), configured to provide an indication of the voltage (V_{DS}) across the first switch (12, S₁).

12. The SMPS (1, 1A, 1B) of any one of the preceding claims,
the first switch (12, S₁) comprising a field-effect transistor, FET.

13. A luminaire (1, 2), comprising
an SMPS (1, 1A, 1B) of any one of the preceding claims, and
a load (2) comprising an LED light source operable by means of the SMPS (1, 1A, 1B).
